# EUROPEAN PATENT APPLICATION

(11) **EP 4 807 562 A1**
(43) Date of publication of application: **16.09.2026**
(21) Application number: 24892726.1
(22) Date of filing: 29.05.2024
(51) Int. Cl.: G06F 11/10, H03M 13/15

(54) **DATA WRITING METHOD AND APPARATUS**

(30) Priority: 22.11.2023 CN 202311572685; 12.01.2024 CN 202410050635
(71) Applicant: Huawei Cloud Computing Technologies Co., Ltd., Guiyang, Guizhou 550025 (CN)
(72) Inventor: XU, Liangliang, Guiyang, Guizhou 550025 (CN); SHAN, Yizhou, Guiyang, Guizhou 550025 (CN); MEN, Yong, Guiyang, Guizhou 550025 (CN); LIU, Qiang, Guiyang, Guizhou 550025 (CN)
(74) Representative: Maiwald GmbH
(86) International application number: PCT/CN2024/095940
(87) International publication number: WO 2025/107561

(57) **Abstract**

Embodiments of this application disclose a data writing method and apparatus, to reduce memory consumption of a client in a distributed storage system. The method in embodiments of this application includes: A client receives a first data block written by a user. The first data block is to be written into a target stripe in a storage device. The client generates a first temporary parity block based on the first data block. The client sends the first data block and the first temporary parity block to a server. The server stores the first data block and the first temporary parity block in the storage device. The server determines that the first data block is a final data block of the target stripe, and performs erasure code combination on the first temporary parity block and a second temporary parity block to obtain a combined target parity block. The second temporary parity block includes one or more temporary parity blocks generated based on another data block in the target stripe other than the first data block. The server stores the target parity block in the storage device.

## Description

This application claims priorities to Chinese Patent Application No. 202311572685.2, filed with the China National Intellectual Property Administration on November 22, 2023 and entitled "DATA PROCESSING METHOD, APPARATUS, AND ANOTHER DEVICE", and to Chinese Patent Application No. 202410050635.6, filed with the China National Intellectual Property Administration on January 12, 2024 and entitled "DATA WRITING METHOD AND APPARATUS", both of which are incorporated herein by reference in their entireties.

### TECHNICAL FIELD

Embodiments of this application relate to the field of cloud computing, and in particular, to a data writing method and apparatus.

### BACKGROUND

With the rapid growth of data volume and the increasing demand for data protection, storage systems adopt erasure coding (erasure coding, EC) techniques to improve reliability. By using EC, they can achieve high data reliability with low redundant storage overheads. In erasure coding, data to be written is split into multiple data blocks, and additional parity blocks are created. These data blocks and parity blocks together form a set with higher redundancy. If any data block is corrupted or lost, the remaining data blocks and parity blocks can be used together to recover the lost data block.

In current erasure-coding-based techniques, for writes that do not yet fill an entire stripe, to improve storage utilization and reduce storage space occupied by parity blocks, incremental erasure coding is used by a client side to write data into a server. To be specific, the client calculates temporary parity blocks for data blocks that are first written into the stripe, and calculates, based on the temporary parity blocks, new temporary parity blocks for subsequent data blocks to be written into the same stripe, until the stripe is fully written with data blocks.

However, in such an incremental erasure coding solution, newly written data blocks in a stripe need to use temporary parity blocks generated from a previous write to calculate new parity blocks. As a result, the client needs to cache a large quantity of temporary parity blocks, leading to insufficient use of memory space of the client. In addition, computing parity blocks based on the written data and the temporary parity blocks incurs high computational complexity on the client, and the server also needs to store a large quantity of parity blocks, causing wastes of storage space.

### SUMMARY

Embodiments of this application provide a data writing method. A client calculates parity blocks based on written data. After a stripe is fully written, a server combines the parity blocks, to reduce memory consumption of the client. Embodiments of this application further provide a data writing apparatus corresponding to the data writing method, a compute device, a compute device cluster, a computer-readable storage medium, and a computer program product.

According to a first aspect, an embodiment of this application provides a data writing method. The method may be performed by a distributed storage system, or may be performed by a part of the distributed storage system, for example, a processor, a chip, or a chip system of the distributed storage system, or may be implemented by a logical module or software that can implement all or some functions of the distributed storage system. In this embodiment of this application, the distributed storage system includes a client and a server. The server is configured to access a storage device, and the storage device is configured to store data that is based on erasure code encoding. The method provided in the first aspect includes: The client receives a first data block written by a user. The first data block is to be written into a target stripe in the storage device. The client generates a first temporary parity block based on the first data block. The client sends the first data block and the first temporary parity block to the server. The server stores the first data block and the first temporary parity block in the storage device. The server determines that the first data block is a final data block of the target stripe, and performs erasure code combination on the first temporary parity block and a second temporary parity block to obtain a combined target parity block. The second temporary parity block includes one or more temporary parity blocks generated based on another data block in the target stripe other than the first data block. The server stores the target parity block in the storage device.

In this embodiment of this application, the client in the distributed storage system obtains a temporary parity block through calculation based on written data. After the stripe of the storage device is fully written, the server combines temporary parity blocks to obtain a target parity block. Compared with a current manner in which the client performs erasure code calculation on a temporary parity block and newly written data, in this embodiment of this application, the client does not need to store the temporary parity block, to reduce memory consumption of the client.

In a possible implementation, the erasure code encoding includes a coefficient multiplication operation and an exclusive OR operation. In a process of performing the erasure code combination on the first temporary parity block and the second temporary parity block, the server performs the exclusive OR operation on the first temporary parity block and the second temporary parity block to obtain the combined target parity block.

In this embodiment of this application, the server can perform the exclusive OR operation based on the first temporary parity block and the second temporary parity block, to obtain the combined target parity block, to reduce a quantity of temporary parity blocks stored in the server, reduce storage space consumed by the server, and improve feasibility of the solution.

In a possible implementation, in a process in which the client generates the first temporary parity block based on the first data block, the client determines that a size of the first data block is greater than or equal to a preset threshold, and splits the first data block into at least one third data block whose size is the preset threshold. The client performs the erasure code encoding on the at least one third data block to generate a third temporary parity block.

In this embodiment of this application, the server can split a data block based on a size of the written data block. When the size of the written data block is greater than the preset threshold, the client may perform the erasure code encoding on the split written data to generate a temporary parity block, to reduce the quantity of temporary parity blocks and save bandwidth for transmission between the client and the server.

In a possible implementation, in a process in which the client generates the first temporary parity block based on the first data block, the client determines that a size of the first data block is less than a preset threshold, and performs the coefficient multiplication operation on the first data block to obtain a fourth temporary parity block. Specifically, the client performs the coefficient multiplication operation on the first data block based on a parity coefficient to obtain the fourth temporary parity block.

In this embodiment of this application, the server can generate the temporary parity block by using different coding schemes based on the size of the written data block, to improve feasibility of the solution.

In a possible implementation, in a process in which the server determines that the first data block is the final data block of the target stripe, the server determines, based on a location identifier of the first data block, that the first data block is the final data block of the target stripe. The location identifier indicates a storage location of the first data block in the target stripe. The server determines, based on the location identifier, that the stripe is fully written and generates the target parity block, that is, the location identifier can indicate an occasion for the server to generate the target parity block.

In this embodiment of this application, the server can identify the final data block of the target stripe based on the location identifier in the written data block, and determine, based on the location identifier in the written data block, an occasion for combining the parity blocks, to improve storage space utilization of the storage device by the server.

In a possible implementation, a size of the location identifier is 2B. For the location identifier, 00 indicates that the stripe is full, 01 indicates that the data block is a start data block of a data portion of the stripe, 10 indicates the data block is a data block on the way of the data portion of the stripe, and 11 indicates that the data block is a final data block of the data portion of the stripe.

In this embodiment of this application, the server can indicate the storage location of the first data block in the target stripe based on content based on the two-byte location identifier, to improve feasibility of the solution.

In a possible implementation, in the process in which the server determines that the first data block is the final data block of the target stripe, the client sends combination indication information to the server. The server receives the combination indication information, and determines that the first data block is the final data block of the target stripe. That is, the client may alternatively control, via a combination indication message, the server to actively combine the parity blocks.

In this embodiment of this application, the server may alternatively receive the combination indication information sent by the client, and determine, based on the combination indication information, that the written data block is the final data block of the target stripe, to improve feasibility of the solution.

In a possible implementation, while generating the first temporary parity block based on the first data block, the client may send the second temporary parity block to the server. That is, the client can send a data block and another temporary parity block to the server while generating the temporary parity block, that is, performs encoding and sending in parallel.

In this embodiment of this application, the client can send the data block to the server while performing the erasure code encoding, so that encoding of the parity block and sending of the data block are performed in parallel, thereby improving data write efficiency of the client.

According to a second aspect, an embodiment of this application provides a distributed storage system. The distributed storage system includes a client and a server. The server is configured to access a storage device. The storage device is configured to store data that is based on erasure code encoding. The client is configured to perform the method performed by the client according to any one of the first aspect or the possible implementations of the first aspect. The server is configured to perform the method performed by the server according to any one of the first aspect or the possible implementations of the first aspect.

According to a third aspect, an embodiment of this application provides a data writing apparatus. The apparatus is used in a distributed storage system. The distributed storage system includes a client and a server. The server is configured to access a storage device. The storage device is configured to store data that is based on erasure code encoding. The apparatus includes a transceiver unit and a processing unit. The transceiver unit is configured to receive a first data block written by a user. The first data block is to be written into a target stripe in the storage device. The processing unit is configured to generate a first temporary parity block based on the first data block. The transceiver unit is further configured to send the first data block and the first temporary parity block to the server. The processing unit is further configured to store the first data block and the first temporary parity block in the storage device. The processing unit is further configured to: determine that the first data block is a final data block of the target stripe, and perform erasure code combination on the first temporary parity block and a second temporary parity block to obtain a combined target parity block. The second temporary parity block includes one or more temporary parity blocks generated based on another data block in the target stripe other than the first data block. The processing unit is further configured to store the target parity block in the storage device.

In a possible implementation, the erasure code encoding includes a coefficient multiplication operation and an exclusive OR operation, and the processing unit is specifically configured to: perform the exclusive OR operation on the first temporary parity block and the second temporary parity block to obtain the combined target parity block.

In a possible implementation, the processing unit is specifically configured to: determine that a size of the first data block is greater than or equal to a preset threshold, and split the first data block into at least one third data block whose size is the preset threshold; and perform the erasure code encoding on the at least one third data block to generate a third temporary parity block.

In a possible implementation, the processing unit is specifically configured to: determine that a size of the first data block is less than a preset threshold, and perform the coefficient multiplication operation on the first data block to obtain a fourth temporary parity block.

In a possible implementation, the processing unit is specifically configured to: determine, based on a location identifier of the first data block, that the first data block is the final data block of the target stripe. The location identifier indicates a storage location of the first data block in the target stripe.

In a possible implementation, the transceiver unit is specifically configured to send combination indication information to the server; and receive the combination indication information, and determine that the first data block is the final data block of the target stripe.

According to a fourth aspect, an embodiment of this application provides a compute device. The compute device includes a processor. The processor is coupled to a memory, and the processor is configured to store instructions. When the instructions are executed by the processor, the compute device is caused to perform the method according to any one of the first aspect or the possible implementations of the first aspect.

According to a fifth aspect, an embodiment of this application provides a compute device cluster. The compute device cluster includes one or more compute devices. The compute device includes a processor. The processor is coupled to a memory, and the processor is configured to store instructions. When the instructions are executed by the processor, the compute device cluster is caused to perform the method according to any one of the first aspect or the possible implementations of the first aspect.

According to a sixth aspect, an embodiment of this application provides a computer-readable storage medium. The computer-readable storage medium stores instructions. When the instructions are executed, a computer is caused to perform the method according to any one of the first aspect or the possible implementations of the first aspect.

According to a seventh aspect, an embodiment of this application provides a computer program product. The computer program product includes instructions. When the instructions are executed, a computer is caused to implement the method according to any one of the first aspect or the possible implementations of the first aspect.

It may be understood that, for beneficial effects that can be achieved by any one of the foregoing distributed storage system, data writing apparatus, compute device, compute device cluster, computer-readable medium, computer program product, or the like, refer to beneficial effects in a corresponding method. Details are not described herein again.

### BRIEF DESCRIPTION OF DRAWINGS

FIG. 1 is a diagram of a system architecture of a distributed storage system according to an embodiment of this application;
FIG. 2 is a schematic flowchart of a data writing method according to an embodiment of this application;
FIG. 3 is a diagram of a data portion and a parity portion of a stripe according to an embodiment of this application;
FIG. 4 is a diagram of a stripe into which a data block is written according to an embodiment of this application;
FIG. 5 is another diagram of a stripe into which a data block is written according to an embodiment of this application;
FIG. 6 is another diagram of a stripe into which a data block is written according to an embodiment of this application;
FIG. 7 is a diagram of parallel coding and writing according to an embodiment of this application;
FIG. 8 is a diagram of combining parity blocks according to an embodiment of this application;
FIG. 9 is a diagram of a data writing apparatus according to an embodiment of this application;
FIG. 10 is a diagram of a structure of a compute device according to an embodiment of this application;
FIG. 11 is a diagram of a structure of a compute device cluster according to an embodiment of this application; and
FIG. 12 is a diagram of a structure of another compute device cluster according to an embodiment of this application.

### DESCRIPTION OF EMBODIMENTS

Embodiments of this application provide a data writing method and apparatus, to reduce bandwidth consumption of a cloud-side server in a data writing process.

In the specification, claims, and accompanying drawings of this application, the terms "first", "second", "third", "fourth", and so on (if existent) are intended to distinguish between similar objects but do not necessarily indicate a specific order or sequence. It should be understood that data used in such a way are interchangeable in proper circumstances, so that embodiments described herein can be implemented in an order other than the order illustrated or described herein. In addition, the terms "include" and "have" and any other variants are intended to cover non-exclusive inclusion. For example, a process, method, system, product, or device that includes a list of steps or units is not necessarily limited to those steps or units that are expressly listed, but may include other steps or units that are not expressly listed or inherent to the process, method, product, or device.

In addition, in embodiments of this application, the word like "example" or "for example" is used to represent giving an example, an illustration, or a description. Any embodiment or design scheme described as an "example" or "for example" in embodiments of this application should not be explained as being more preferred or having more advantages than another embodiment or design scheme. To be precise, usage of the word like "example" or "for example" is intended to present a related concept in a specific manner.

First, some terms in embodiments of this application are described, to help a person skilled in the art understand the technical solutions.

A stripe (stripe) is a unit of data distribution. In the data distribution, consecutive data blocks are evenly distributed to multiple disk drives, and a system is allowed to perform read and write from the multiple disks at the same time, to process I/O operations in parallel. Data in the stripe is physically split. For example, a part of a file may be stored in one disk, and another part may be stored in another disk. Such data distribution enables data to be read from or written to the multiple disks at the same time, greatly increasing a data throughput.

To make the technical solutions of this application clearer and easier to understand, the following describes a system architecture of this application with reference to the accompanying drawings.

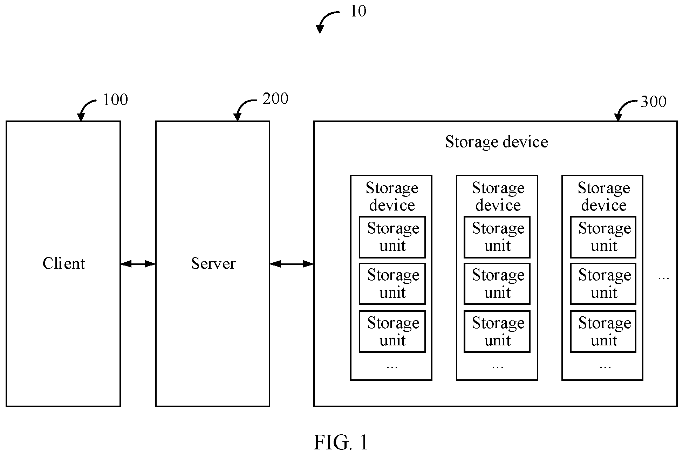

FIG. 1 is a diagram of a system architecture of a data writing system according to an embodiment of this application. In the system architecture shown in FIG. 1, a distributed storage system 10 includes a client 100, a server 200, and a storage device 300. The storage device 300 includes one or more storage devices distributed in different data centers. The client 100 generates a parity block for written data based on an erasure code algorithm, and writes the data and the parity block into the server 200. The server 200 stores a data block and the parity block that are written by the client 100. The following separately describes specific functions of the client 100 and the server 200.

The client 100 is a device or an application program that initiates a storage request to the server 200. Specifically, the client 100 can split the written data into blocks, and encode the data blocks based on the erasure code algorithm to generate parity blocks. The client 100 uploads both the data blocks and the parity blocks to the server 200, and the server 200 stores the data blocks and the parity blocks in a distributed manner in multiple storage devices of data centers in different areas, to improve fault tolerance of the data.

The client 100 is further configured to download data and recover a faulty data block via the server 200. For example, if a data block is corrupted or lost in a transmission process, the client 100 may reconstruct complete data based on remaining data blocks and parity blocks.

It may be understood that the client 100 may be different devices or application programs in different application scenarios. For example, in a personal storage scenario, the client 100 may be a terminal device like a personal computer, a smartphone, or a tablet computer, or may be a software client on the terminal device, for example, an application program. The client 100 uploads the data to a cloud storage server through a network.

In an enterprise application scenario, the client 100 may be a file server, a database server, or an application server. After encoding internal data, the client 100 sends the data to a data center or a private cloud storage. In an internet of things application scenario, the client 100 may be a sensor or a device, and the client 100 generates data and sends the data to a back-end server for analysis and backup.

The server 200 is a device that maintains a storage resource and processes a storage request of the client 100. Specifically, the server 200 is configured to receive the data blocks and the parity blocks that are sent by the client 100, and store the data blocks and the parity blocks in the storage device 300. The storage device 300 includes the one or more storage devices in the data centers distributed in different areas.

The server 200 is further configured to perform erasure code encoding again on the parity blocks generated by the client 100, to generate a combined parity block, and store the combined parity block in the storage device 300. The server 200 is further configured to allow recovery of a data block from one or more disk block or storage node failures.

It may be understood that the distributed storage device 200 may be different devices in different application scenarios. In some scenarios, the distributed storage device 300 may alternatively be a distributed disk array in a single storage server. This is not specifically limited.

The distributed storage 300 may be further used in a storage device in another application scenario. For example, the distributed storage 300 may alternatively be a storage device in a data center application scenario, a distributed file system application scenario, or a redundancy backup scenario.

The client 100 and the server 200 in this embodiment of this application may be separately deployed in different devices, or may be deployed in a same device. This is not specifically limited.

Based on the distributed storage system 10 shown in FIG. 1, this application further provides a data writing method. The following describes the data writing method provided in embodiments of this application with reference to embodiments.

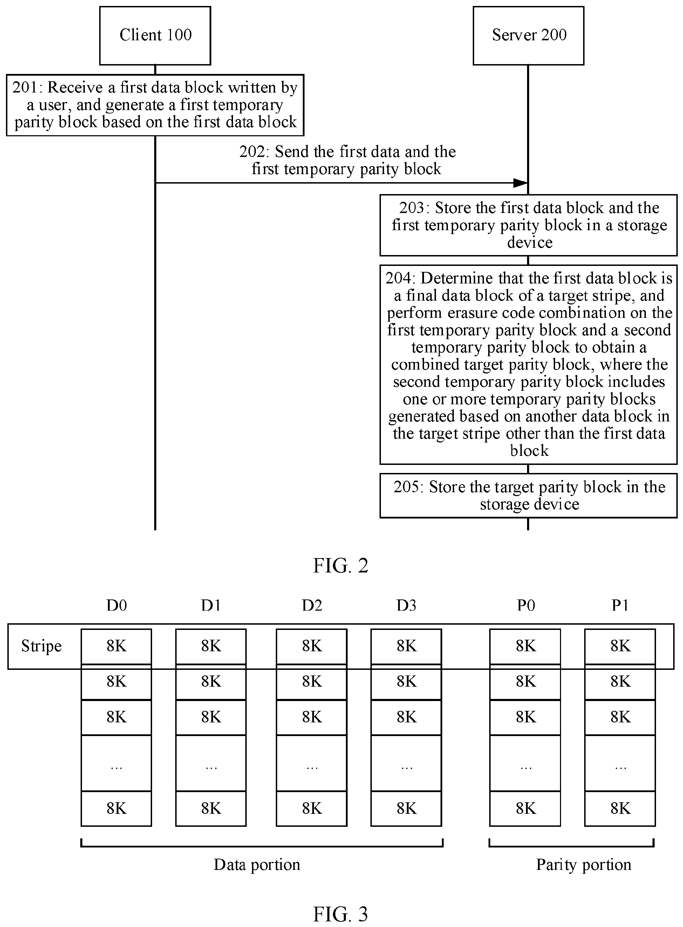

FIG. 2 is a schematic flowchart of a data writing method according to an embodiment of this application. In an example shown in FIG. 2, the method includes the following steps.

Step 201: A client receives a first data block written by a user, and generates a first temporary parity block based on the first data block.

The client 100 receives the first data block. The first data block is data that needs to be stored in a stripe of a storage device 300. The client 100 generates the first temporary parity block based on the first data block. The stripe is a unit of data distribution in a server 200, and the stripe may be physically split. For example, one stripe may include storage space of different disk blocks.

Specifically, in a process in which the client 100 generates the parity block based on the first data block, the client 100 needs to split written data based on a size of the first data block, generate the first temporary parity block based on a data block obtained through division, and store the data block and the first temporary parity block in the server 200. The first data block and the first temporary parity block may be separately stored in different storage devices.

FIG. 3 is a diagram of a stripe that is of a storage device and into which a data block is written according to an embodiment of this application. In an example shown in FIG. 3, the client 100 needs to write the written data into the stripe of the storage device 300. It can be learned from the example shown in FIG. 3 that the storage device 300 includes six disk blocks, the six disk blocks may be distributed in different storage devices, and a size of each disk block is, for example, 1M. Among the six disk blocks, four disks are configured to store data blocks, and are respectively D0, D1, D2, and D3; and the two disk blocks are used for storing parity blocks, and are respectively P0 and P1.

In the example shown in FIG. 3, storage space of each disk block may be divided into different units (units), and a division granularity of each unit is, for example, 8K. Units of different disk blocks form a stripe. For example, units of each row of six disk blocks in FIG. 3 form a stripe, that is, a size of the stripe is 48K. In the stripe, a part used for storing data blocks is referred to as a data portion of the stripe, and a part used for storing parity blocks is referred to as a parity portion of the stripe. For example, the first four 8K units in the stripe are a data portion of the stripe, and the last two 8K units in the stripe are a parity portion of the stripe.

In the example shown in FIG. 3, the server 200 stores a received data block in the data portion of the stripe, and the server 200 stores a received parity block in the parity portion of the stripe. It should be noted that when the data portion of the stripe cannot be fully stored with data blocks received by the server 200 at a time, the server 200 may sequentially store data blocks in a remaining data portion of the stripe until the data portion of the stripe is fully stored, to improve storage space utilization of the data portion of the stripe. After the data portion of the stripe is fully stored, the server 200 stores a data block in a data portion of a next stripe.

In this embodiment of this application, the client 100 may generate the first temporary parity block in different manners based on the size of the written first data block. The first temporary parity block includes a third temporary parity block and a fourth temporary parity block. Detailed descriptions are provided below.

In a possible implementation, when the written first data block is greater than a first threshold, where the first threshold is, for example, a size of a unit, namely, 8K, written data greater than the first threshold is also referred to as large input/output (I/O) data in this embodiment of this application. The client 100 splits, based on the first threshold, the written first data block into at least one third data block whose size is a preset threshold, and performs erasure code encoding on the at least one third data block to generate the third temporary parity block.

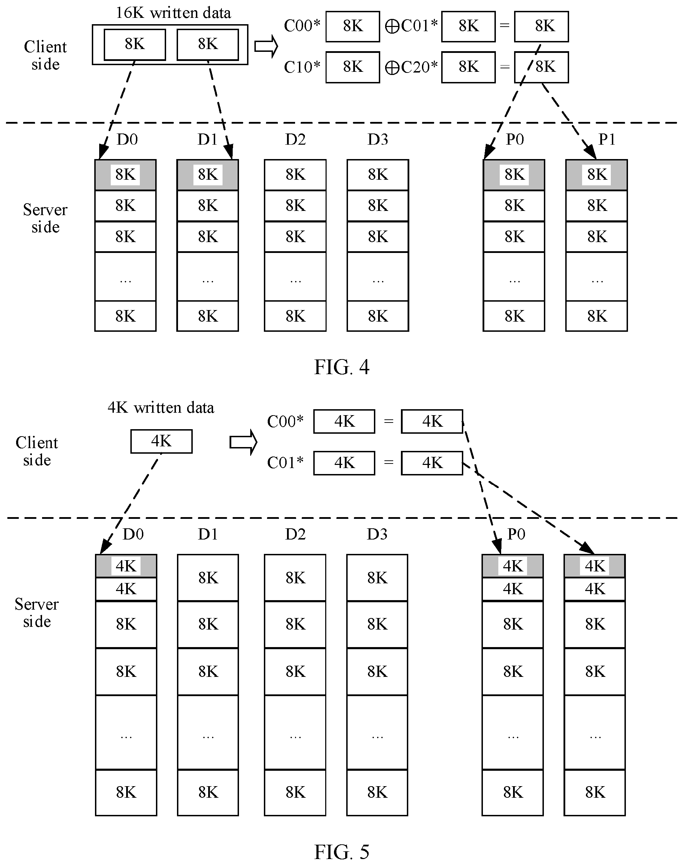

FIG. 4 is a diagram of splitting written data into blocks and generating parity blocks according to an embodiment of this application. In an example shown in FIG. 4, when the written data is greater than the first threshold, the client 100 splits the written data into different data blocks based on the first threshold, and performs erasure code calculation on the different data blocks to obtain the third temporary parity block.

For example, in the example shown in FIG. 4, when the written data is 16K data, because the 16K data is greater than the first threshold 8K, the client 100 splits the 16K written data based on 8K, to obtain two 8K data segments. The client 100 performs the erasure code calculation twice on the two 8K data segments, to obtain two 8K parity blocks. Specifically, in a process in which the client 100 performs the erasure code calculation twice on the two 8K data segments, during the first calculation, the two 8K data blocks are respectively multiplied by parity coefficients C00 and C01, and then an exclusive OR (XOR) operation is performed to obtain a 1^{st} parity block; and during the second calculation, the two 8K data blocks are respectively multiplied by parity coefficients C10 and C20, and the exclusive OR (XOR) operation is performed to obtain a 2^{nd} parity block.

In a possible implementation, when the written first data block is less than or equal to the first threshold, where the first threshold is, for example, a size of a unit, namely, 8K, written data less than or equal to the first threshold is also referred to as small input/output (I/O) data in this embodiment of this application. The client 100 performs a coefficient multiplication operation on the first data block based on a parity coefficient to obtain the fourth temporary parity block.

FIG. 5 is a diagram of splitting written data into blocks and generating parity blocks according to an embodiment of this application. In an example shown in FIG. 5, when the written data is less than or equal to the first threshold, in the process in which the client 100 generates the first temporary parity block based on the written data, the coefficient multiplication operation is performed on the written data based on the parity coefficient, to obtain the fourth temporary parity block.

For example, in the example shown in FIG. 5, when the written data is 4K data, because the 4K data is less than the first threshold 8K, the client 100 performs the erasure code encoding twice on the 4K written data based on different parity coefficients, to obtain two 4K parity blocks. Specifically, in the process of performing replication twice on the 4K data block based on different parity coefficients, the client 100 multiplies the 4K data block by two different parity coefficients C00 and C01 respectively, to obtain two parity blocks.

Step 202: The client sends the first data block and the first temporary parity block to the server.

After generating the first temporary parity block based on the first data block, the client 100 sends first data and the first temporary parity block to the server 200.

Step 203: The server stores the first data block and the first temporary parity block in the storage device.

After receiving the first data block and the first temporary parity block that are sent by the client 100, the server 200 stores the first data block and the first temporary parity block in the storage device. Specifically, the server 200 stores the received data block in a disk block that is in the storage device and that is used for storing the data block, that is, the data portion of the stripe in the storage device 300, and stores the first temporary parity block in a disk block that is in the storage device and that is used for storing the parity block, that is, the parity portion of the stripe in the storage device 300.

Still refer to FIG. 4. In the example shown in FIG. 4, the client 100 sends two 8K data blocks and two 8K parity blocks to the server 200. The server 200 stores the two 8K data blocks in units of the disk block D0 and the disk block D1 respectively, that is, the first two units of the data portion of the stripe, and stores the two 8K parity blocks in units of the disk block P0 and the disk block P1 respectively.

Still refer to FIG. 5. In the example shown in FIG. 5, the client 100 sends one 4K data block and two 4K parity blocks to the server 200. The server 200 stores the 4K data block in a unit of the disk block D0, that is, a 1^{st} unit of the data portion of the stripe, and stores the two 4K parity blocks in units of the disk block P0 and the disk block P1 respectively.

It should be noted that, in an append-write scenario, the server 200 sequentially writes received data blocks corresponding to multiple pieces of written data into the data portion of the stripe in the server 200. When the server 200 fully writes the data portion of the stripe, the server 200 continues to write the data blocks into a data portion of a new stripe. In addition, the server 200 also sequentially writes parity blocks corresponding to the multiple pieces of written data into the disk block used for storing the parity block.

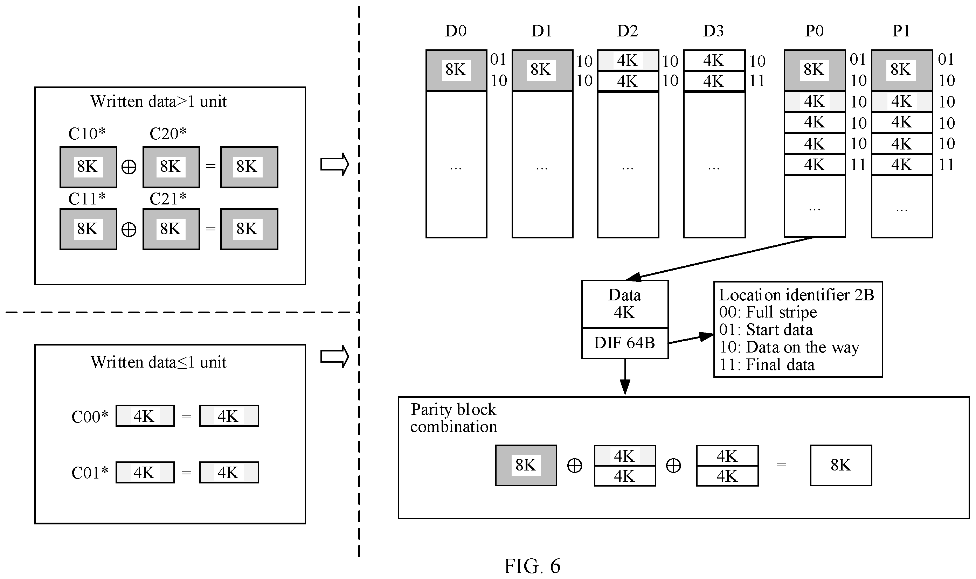

FIG. 6 is a schematic flowchart of another data writing method according to an embodiment of this application. In an example shown in FIG. 6, the client 100 needs to write 16K written data into the server 200. The client 100 first splits the 16K written data into blocks to obtain two 8K data blocks, and performs erasure code calculation twice on the two 8K data blocks to obtain two 8K parity blocks. The client 100 sends the two 8K data blocks and the two 8K parity blocks to the server 200. The server 200 stores the two 8K data blocks in the units of the disk block D0 and the disk block D1 respectively, and stores the two 8K parity blocks in the units of the disk block P0 and the disk block P1 respectively.

Then, the client 100 needs to continue to write 4K written data into the server 200. The client 100 obtains two 4K parity blocks based on the 4K written data, and sends the 4K data block and the two 4K parity blocks to the server 200. The server 200 continues to store the 4K data block in the unit of the disk block D2, and continues to store the two 4K parity blocks in the units of the disk block P0 and the disk block P1 respectively.

In the example shown in FIG. 6, when the client 100 needs to continue to write data into the server 200, the server 200 sequentially stores received data blocks in remaining storage space of the data portion of the stripe until the data portion of the stripe is fully written. For example, the server 200 continues to store a 4K data block received for a third time in the remaining 4K storage space of the unit of the disk block D2. The server 200 continues to store a 4K data block received for a fourth time and a 4K data block received for a fifth time in storage space of the unit of the disk block D3.

In this embodiment of this application, when the client 100 writes data into the data portion of the stripe, the client 100 maintains a data integrity field (data integrity field, DIF) for each data block. For example, the client 100 maintains a data integrity field for the 4K data block, and a size of the data integrity field is 64B.

The data integrity field includes a location identifier, a size of the location identifier is 2B, and the location identifier is used to record a location of the data block in the data portion of the stripe. For example, 00 indicates that the stripe is full (full stripe), 01 indicates that the data block is a start data block (start) of the data portion of the stripe, 10 indicates that the data block is a data block on the way (on the way) of the data portion of the stripe, and 11 indicates that the data block is a final data block (final) of the data portion of the stripe.

It may be understood that, the data integrity field may also be maintained for the parity block corresponding to the data block, and the location identifier corresponding to the parity block indicates the location of the data block corresponding to the parity block in the data portion of the stripe.

Still refer to FIG. 6. In the example shown in FIG. 6, a 64B data integrity field is maintained for each piece of 4K data stored in the server 200. 2B in the data integrity field is a location identifier, and the location identifier is used to record a location of a data block in a data portion of a stripe. For example, a location identifier corresponding to a 1^{st} piece of 4K data in the disk block D0 of the stripe is 01, a location identifier corresponding to a 1^{st} piece of 4K data in the disk block D2 of the stripe is 10, and a location identifier of a 2^{nd} piece of 4K data in the disk block D3 of the stripe is 11.

In a possible implementation, while generating the first temporary parity block based on the first data block, the client 100 may send a second temporary parity block to the server 200. That is, the client 100 can send a data block and another parity block to the server 200 while generating the parity block, that is, performs encoding and sending in parallel.

Continue to refer to FIG. 6. In the example shown in FIG. 6, the client 100 needs to write 16K written data into the storage device 300. The client 100 first splits the 16K written data into blocks to obtain two 8K data blocks, and performs erasure code calculation twice on the two 8K data blocks to obtain two 8K parity blocks. While the client 100 performs the erasure code calculation on the two 8K data blocks, the client 100 may send two 8K data blocks to the server 200.

In the example shown in FIG. 6, when the client 100 needs to continue to write 4K written data into the server 200, the client 100 generates two 4K parity blocks based on the 4K written data. While generating the 4K parity blocks, the client 100 may also send, to the server 200, the 8K parity block generated through the previous calculation.

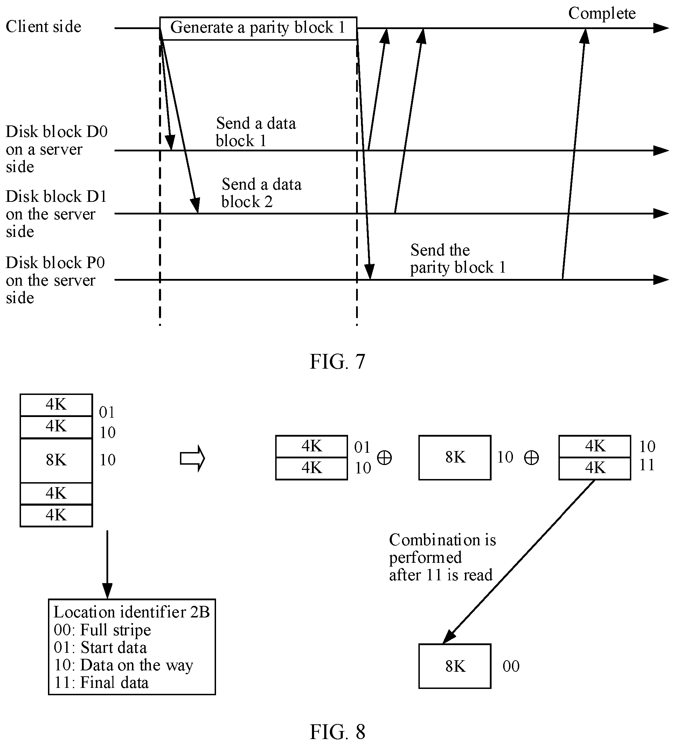

FIG. 7 is a diagram of parallel processing of generating a parity block and sending a data block by a client according to an embodiment of this application. In an example shown in FIG. 7, while generating the parity block by performing erasure code calculation based on the data block, the client 100 may send the data block to the server 200. For example, in a process in which the client 100 performs the erasure code calculation based on a data block 1 and a data block 2 to obtain a parity block 1, the client 100 may write the data block 1 into the disk block D0 of the server 200 and write the data block 1 into the disk block D1 of the server 200 in parallel.

In the example shown in FIG. 7, after performing the erasure code calculation based on the data block 1 and the data block 2 to obtain the parity block 1, the client 100 writes the parity block 1 into the disk block P0 of the server 200. In this case, the client 100 may perform the erasure code calculation based on the data block 1 and the data block 2 in parallel to obtain a new parity block.

Step 204: The server determines that the first data block is a final data block of a target stripe, and performs erasure code combination on the first temporary parity block and the second temporary parity block to obtain a combined target parity block, where the second temporary parity block includes one or more temporary parity blocks generated based on another data block in the target stripe other than the first data block. After the server 200 receives the first temporary parity block sent by the client 100, when the first temporary parity block is a parity block generated for the final data block of the stripe, the server 200 performs the erasure code calculation on the first temporary parity block and the second temporary parity block to obtain the target parity block. The target parity block may also be referred to as a combined parity block in this application, and the second temporary parity block includes the one or more parity blocks generated based on the another data block in the stripe other than the final data block.

In other words, when the data portion of the stripe in the server 200 is fully written, the server 200 combines the parity blocks corresponding to the data blocks in the stripe once to obtain the target parity block. Specifically, the server 200 identifies, based on a location identifier of the temporary parity block, an occasion for combining the parity blocks. When the location identifier indicates that the parity block is a parity block corresponding to the final data block of the data portion of the stripe, the server 200 combines all the parity blocks corresponding to the data blocks of the data portion of the stripe once, to obtain the target parity block.

Still refer to FIG. 6. In the example shown in FIG. 6, the client 100 writes a data block into the data portion of the stripe of the storage device 300. For example, the 16K data is written for the first time and is separately stored in the disk blocks D0 and D1 of the data portion of the stripe; the 4K data is written for the second time and is stored in the disk block D2 of the data portion of the stripe; the 4K data is written for the third time and is also stored in the disk block D2 of the data portion of the stripe; the 4K data is written for the fourth time and stored in the disk block D3 of the data portion of the stripe; and the 4K data is written for the fifth time and stored in the disk block D3 of the data portion of the stripe. The stripe is full after the fifth writing.

Correspondingly, in the example shown in FIG. 6, the two 8K parity blocks corresponding to the 16K data block written by the client 100 for the first time are stored in the disk blocks P0 and P1. Because the 16K data is a start data block of the stripe, a location identifier of the parity block is 01. The two 4K parity blocks corresponding to the 4K data block written by the client 100 for the second time are also stored in disk blocks P0 and P1, the two 4K parity blocks corresponding to the 4K data block written by the client 100 for the third time are also stored in disk blocks P0 and P1, and the two 4K parity blocks corresponding to the 4K data block written by the client 100 for the fourth time are stored in the disk blocks P0 and P1. Because the data written for the second time to the fourth time is data blocks on the way of the stripe, location identifiers of the three parity blocks written for the second time to the fourth time are 10. The two 4K parity blocks corresponding to the 4K data block written by the client 100 for the fifth time are stored in the disk blocks P0 and P1. Because the 16K data is the start data block of the stripe, a location identifier of the parity block is 11.

In the example shown in FIG. 6, when the server 200 identifies that the location identifier of the parity block is 11, the server 200 combines the parity blocks, and the server 200 combines all parity blocks corresponding to the data blocks in the data portion of the stripe. To be specific, the server 200 combines the 8K parity blocks written for the first time, the 4K parity blocks written for the second time, the 4K parity blocks written for the third time, the 4K parity blocks written for the fourth time, and the 4K parity blocks written for the fifth time, to obtain a combined 8K parity block. After obtaining the combined parity block, the server 200 rewrites the combined parity block into the disk block of the parity portion of the stripe.

In a possible implementation, in addition to the occasion for combining the temporary parity blocks by the server 200 to generate the target parity block after the data portion of the stripe is fully written, the client 100 may alternatively control the server 200 to actively combine the parity blocks. This is not specifically limited. For example, the client 100 sends combination indication information to the server 200. The server 200 receives the combination indication information, and determines, based on the combination indication information, that the first data block is the final data block of the target stripe.

FIG. 8 is a diagram of combining parity blocks according to an embodiment of this application. In an example shown in FIG. 8, the server 200 combines five parity blocks. A location identifier of a 1^{st} 4K parity block is 01, namely, a parity block corresponding to a start data block of a stripe, and a location identifier of a 5^{th} 4K parity block is 11, namely, a parity block corresponding to a final data block of the stripe.

In the example shown in FIG. 8, in a process in which the server 200 combines the five parity blocks, the server 200 performs combination and verification at a granularity of an 8K unit. To be specific, the server 200 combines two 4K parity blocks into one 8K parity block, and performs an exclusive OR operation on the three 8K parity blocks to obtain a combined 8K parity block. A location identifier of the combined 8K parity block is 00, that is, indicates a parity block corresponding to a full stripe.

Step 205: The server 200 stores the target parity block in the storage device.

After performing the erasure code combination on the first temporary parity block and the second temporary parity block to obtain the combined target parity block, the server 200 stores the target parity block in the storage device 300.

It can be learned from the foregoing embodiment that, in this embodiment of this application, the client in the distributed storage system obtains the temporary parity block through calculation based on the written data, and after the stripe of the storage device is fully written, the server combines the temporary parity blocks to obtain the target parity block. In this way, the client does not need to store the temporary parity block, to reduce memory consumption of the client in a data writing process.

Based on the foregoing method embodiment, an embodiment of this application further provides a data writing apparatus. The following specifically describes the data writing apparatus provided in embodiments of this application.

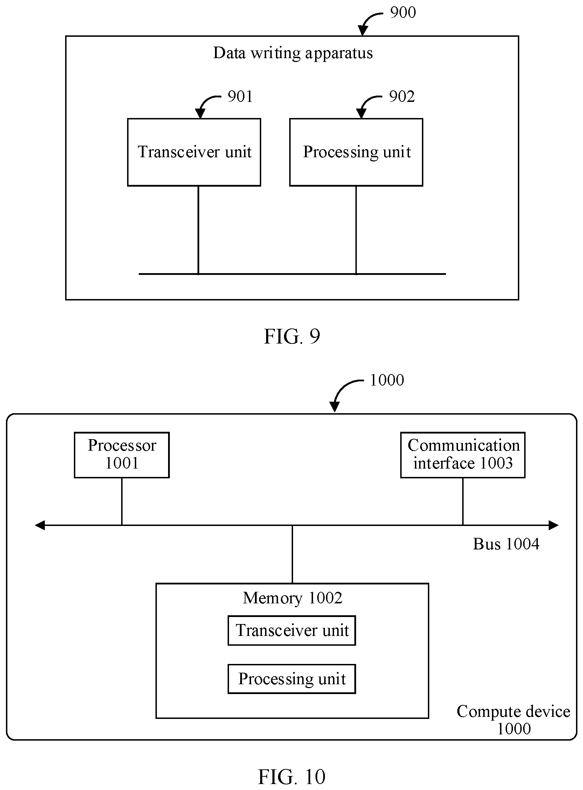

FIG. 9 is a diagram of a structure of a data writing apparatus according to an embodiment of this application. In an example shown in FIG. 9, the data writing apparatus 900 is configured to implement steps performed by the distributed storage system in the foregoing embodiments. The data writing apparatus 900 includes a transceiver unit 901 and a processing unit 902.

The transceiver unit 901 is configured to receive a first data block written by a user. The first data block is to be written into a target stripe in a storage device. The processing unit 902 is configured to generate a first temporary parity block based on the first data block. The transceiver unit 901 is further configured to send the first data block and the first temporary parity block to a server. The processing unit 902 is further configured to store the first data block and the first temporary parity block in the storage device. The processing unit 902 is further configured to: determine that the first data block is a final data block of the target stripe, and perform erasure code combination on the first temporary parity block and a second temporary parity block to obtain a combined target parity block. The second temporary parity block includes one or more temporary parity blocks generated based on another data block in the target stripe other than the first data block. The processing unit 902 is further configured to store the target parity block in the storage device.

In a possible implementation, the erasure code encoding includes a coefficient multiplication operation and an exclusive OR operation, and the processing unit 902 is specifically configured to: perform the exclusive OR operation on the first temporary parity block and the second temporary parity block to obtain the combined target parity block.

In a possible implementation, the processing unit 902 is specifically configured to: determine that a size of the first data block is greater than or equal to a preset threshold, and split the first data block into at least one third data block whose size is the preset threshold; and perform the erasure code encoding on the at least one third data block to generate a third temporary parity block.

In a possible implementation, the processing unit 902 is specifically configured to: determine that a size of the first data block is less than a preset threshold, and perform the coefficient multiplication operation on the first data block to obtain a fourth temporary parity block.

In a possible implementation, the processing unit 902 is specifically configured to: determine, based on a location identifier of the first data block, that the first data block is the final data block of the target stripe. The location identifier indicates a storage location of the first data block in the target stripe.

In a possible implementation, the transceiver unit 901 is specifically configured to send combination indication information to the server; and receive the combination indication information, and determine that the first data block is the final data block of the target stripe.

It should be understood that division of the units in the foregoing apparatus is merely logical function division. During actual implementation, all or some of the units may be integrated into one physical entity, or may be physically separated. In addition, all the units in the apparatus may be implemented in a form of software invoked by a processing element, or may be implemented in a form of hardware; or some units may be implemented in a form of software invoked by a processing element, and some units may be implemented in a form of hardware. For example, each unit may be a separately disposed processing element, or may be integrated into a chip of the apparatus for implementation. In addition, each unit may alternatively be stored in a memory in a form of a program to be invoked by a processing element of the apparatus to perform a function of the unit. In addition, all or some of the units may be integrated, or may be implemented independently. The processing element herein may also be referred to as a processor, and may be an integrated circuit having a signal processing capability. During implementation, steps in the foregoing method or the foregoing units may be implemented by using a hardware integrated logic circuit in a processor element, or may be implemented in the form of software invoked by the processing element.

It should be noted that, for brief description, the foregoing method embodiments are represented as a series of actions. However, a person skilled in the art should know that this application is not limited to the described order of the actions. In addition, a person skilled in the art should also know that all the embodiments described in this specification are examples of embodiments, and the related actions are not necessarily mandatory to this application.

Another appropriate step combination that can be figured out by a person skilled in the art based on the content described above also falls within the protection scope of this application. In addition, a person skilled in the art should also be familiar to all the embodiments described in this specification are example of embodiments, and the related actions are not necessarily mandatory to this application.

FIG. 10 is a diagram of a structure of a compute device according to an embodiment of this application. As shown in FIG. 10, the compute device 1000 includes a processor 1001, a memory 1002, a communication interface 1003, and a bus 1004. The processor 1001, the memory 1002, and the communication interface 1003 are coupled through the bus (not marked in the figure). The memory 1002 stores instructions. When the executable instructions in the memory 1002 are executed, the compute device 1000 performs the method performed by the compute device in the foregoing method embodiment.

The compute device 1000 may be one or more integrated circuits configured to implement the foregoing method, for example, one or more application-specific integrated circuits (application-specific integrated circuits, ASICs), one or more microprocessors (digital signal processors, DSPs), one or more field programmable gate arrays (field programmable gate arrays, FPGAs), or a combination of at least two of these integrated circuit forms. For another example, when the unit in the apparatus is implemented in a form of scheduling a program by a processing element, the processing element may be a general-purpose processor, for example, a central processing unit (central processing unit, CPU) or another processor that may invoke the program. For still another example, the units may be integrated and implemented in a form of a system-on-a-chip (system-on-a-chip, SoC).

The processor 1001 may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware part, or any combination thereof. The general-purpose processor may be a microprocessor or any regular processor or the like.

The memory 1002 may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The memory 1002 stores executable program code, and the processor 1001 executes the executable program code to separately implement functions of the foregoing units or modules, to implement the foregoing data writing method. That is, the memory 1002 stores instructions used for performing the foregoing data writing method.

The communication interface 1003 uses a transceiver module, for example, but not limited to, a network interface card or a transceiver, to implement communication between the compute device 1000 and another device or a communication network.

In addition to a data bus, the bus 1004 may further include a power bus, a control bus, a status signal bus, and the like. The bus may be a peripheral component interconnect express (peripheral component interconnect express, PCIe) bus, an extended industry standard architecture (extended industry standard architecture, EISA) bus, a unified bus (unified bus, Ubus, or UB), a compute express link (compute express link, CXL), a cache coherent interconnect for accelerators (cache coherent interconnect for accelerators, CCIX), or the like. The bus may be classified into an address bus, a data bus, a control bus, or the like.

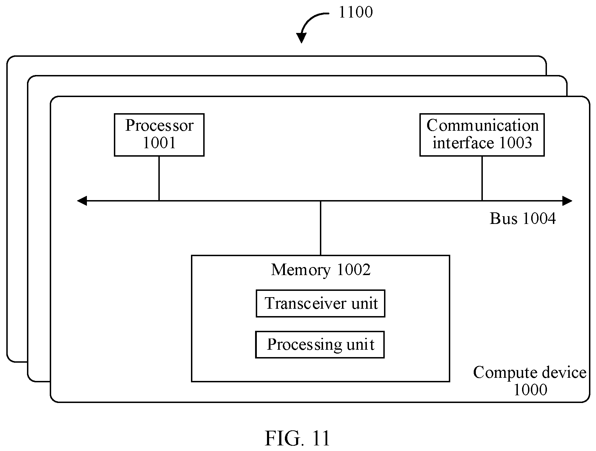

FIG. 11 is a diagram of a compute device cluster according to an embodiment of this application. As shown in FIG. 11, the compute device cluster 1100 includes at least one compute device 1000.

As shown in FIG. 11, the compute device cluster 1100 includes at least one compute device 1000. Memories 1002 in one or more compute devices 1000 in the compute device cluster 1100 may store same instructions for performing the foregoing data writing method.

In some possible implementations, the memories 1002 in the one or more compute devices 1000 in the compute device cluster 1100 may separately store a part of the instructions for performing the data writing method. In other words, a combination of the one or more compute devices 1000 may jointly execute the instructions used for perform the foregoing data writing method.

It should be noted that memories 1002 of different compute devices 1000 in the compute device cluster 1100 may store different instructions respectively used for perform a part of functions of the foregoing data writing apparatus. That is, the instructions stored in the memories 1002 in the different compute devices 1000 may be used for implementing functions of one or more modules in a transceiver unit and a processing unit.

In some possible implementations, the one or more compute devices 1000 in the compute device cluster 1100 may be connected through a network. The network may be a wide area network, a local area network, or the like.

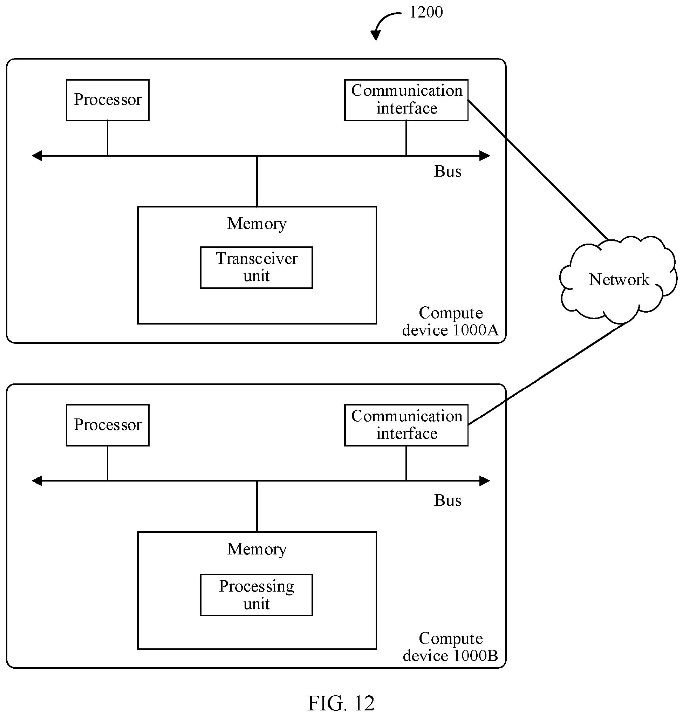

FIG. 12 is a diagram in which compute devices in a computing cluster are connected through a network according to an embodiment of this application. As shown in FIG. 12, two compute devices 1000A and 1000B are connected through the network. Specifically, each compute device is connected to the network through a communication interface in the compute device.

In a possible implementation, a memory in the compute device 1000A stores instructions for performing a function of a transceiver unit. In addition, a memory in the compute device 1000B stores instructions for performing functions of a processing unit and a display unit.

It should be understood that a function of the compute device 1000A shown in FIG. 12 may alternatively be completed by multiple compute devices. Similarly, a function of the compute device 1000B may alternatively be completed by multiple compute devices.

In another embodiment of this application, a computer-readable storage medium is further provided. The computer-readable storage medium stores computer-executable instructions. When a processor of a device executes the computer-executable instructions, the device performs the method performed by the compute device in the foregoing method embodiment.

In another embodiment of this application, a computer program product is further provided. The computer program product includes computer-executable instructions, and the computer-executable instructions are stored in a computer-readable storage medium. When a processor of a device executes the computer-executable instructions, the device performs the method performed by the compute device in the foregoing method embodiment.

It may be clearly understood by a person skilled in the art that, for the purpose of convenient and brief description, for detailed working processes of the foregoing system, apparatus, and unit, refer to corresponding processes in the foregoing method embodiments. Details are not described herein again.

In the several embodiments provided in this application, it should be understood that the disclosed system, apparatus, and method may be implemented in other manners. For example, the foregoing apparatus embodiments are merely examples. For example, the unit division is merely logical function division and may be other division during actual implementation. For example, multiple units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the current technology, or all or some of the technical solutions may be implemented in the form of a software product. The computer software product is stored in a storage medium and includes several instructions for instructing a computer device (which may be a personal computer, a server, or a network device) to perform all or some of the steps of the methods described in embodiments of this application. The foregoing storage medium includes any medium that can store program code, for example, a USB flash drive, a removable hard disk, a read-only memory (ROM, read-only memory), a random access memory (RAM, random access memory), a magnetic disk, or an optical disc.

## Claims

1. A data writing method, wherein the method is applied to a distributed storage system, the distributed storage system comprises a client and a server, the server is configured to access a storage device, the storage device is configured to store data that is based on erasure code encoding, and the method comprises:
receiving, by the client, a first data block written by a user, wherein the first data block is to be written into a target stripe in the storage device;
generating, by the client, a first temporary parity block based on the first data block;
sending, by the client, the first data block and the first temporary parity block to the server;
storing, by the server, the first data block and the first temporary parity block in the storage device;
determining, by the server, that the first data block is a final data block of the target stripe, and performing erasure code combination on the first temporary parity block and the second temporary parity block to obtain a combined target parity block, wherein the second temporary parity block comprises one or more temporary parity blocks generated based on another data block in the target stripe other than the first data block; and
storing, by the server, the target parity block in the storage device.

2. The method according to claim 1, wherein the erasure code encoding comprises a coefficient multiplication operation and an exclusive OR operation, and the performing the erasure code combination on the first temporary parity block and the second temporary parity block comprises:
performing, by the server, the exclusive OR operation on the first temporary parity block and the second temporary parity block to obtain the combined target parity block.

3. The method according to claim 1 or 2, wherein the generating, by the client, the first temporary parity block based on the first data block comprises:
determining, by the client, that a size of the first data block is greater than or equal to a preset threshold, and splitting the first data block into at least one third data block whose size is the preset threshold; and
performing, by the client, the erasure code encoding on the at least one third data block to generate a third temporary parity block.

4. The method according to claim 1 or 2, wherein the generating, by the client, the first temporary parity block based on the first data block comprises:
determining, by the client, that a size of the first data block is less than the preset threshold, and performing the coefficient multiplication operation on the first data block to obtain a fourth temporary parity block.

5. The method according to any one of claims 1 to 4, wherein the determining, by the server, that the first data block is the final data block of the target stripe comprises:
determining, by the server based on a location identifier of the first data block, that the first data block is the final data block of the target stripe, wherein the location identifier indicates a storage location of the first data block in the target stripe.

6. The method according to any one of claims 1 to 4, wherein the determining, by the server, that the first data block is the final data block of the target stripe comprises:
sending, by the client, combination indication information to the server; and
receiving, by the server, the combination indication information, and determining that the first data block is the final data block of the target stripe.

7. A distributed storage system, wherein the distributed storage system comprises a client and a server, the server is configured to access a storage device, the storage device is configured to store data that is based on erasure code encoding, the client is configured to perform the method performed by the client according to any one of claims 1 to 6, and the server is configured to perform the method performed by the server according to any one of claims 1 to 6.

8. A data writing apparatus, wherein the apparatus is used in a distributed storage system, the distributed storage system comprises a client and a server, the server is configured to access a storage device, the storage device is configured to store data that is based on erasure code encoding, and the apparatus comprises:
a transceiver unit, configured to receive a first data block written by a user, wherein the first data block is to be written into a target stripe in the storage device; and
a processing unit, configured to generate a first temporary parity block based on the first data block, wherein
the transceiver unit is further configured to send the first data block and the first temporary parity block to the server;
the processing unit is further configured to store the first data block and the first temporary parity block in the storage device;
the processing unit is further configured to: determine that the first data block is a final data block of the target stripe, and perform erasure code combination on the first temporary parity block and the second temporary parity block to obtain a combined target parity block, wherein the second temporary parity block comprises one or more temporary parity blocks generated based on another data block in the target stripe other than the first data block; and
the processing unit is further configured to store the target parity block in the storage device.

9. The apparatus according to claim 8, wherein the erasure code encoding comprises a coefficient multiplication operation and an exclusive OR operation, and the processing unit is specifically configured to:
perform the exclusive OR operation on the first temporary parity block and the second temporary parity block to obtain the combined target parity block.

10. The apparatus according to claim 8 or 9, wherein the processing unit is specifically configured to:
determine that a size of the first data block is greater than or equal to a preset threshold, and split the first data block into at least one third data block whose size is the preset threshold; and
perform the erasure code encoding on the at least one third data block to generate a third temporary parity block.

11. The apparatus according to claim 8 or 9, wherein the processing unit is specifically configured to:
determine that a size of the first data block is less than the preset threshold, and perform the coefficient multiplication operation on the first data block to obtain a fourth temporary parity block.

12. The apparatus according to any one of claims 8 to 11, wherein the processing unit is specifically configured to:
determine, based on a location identifier of the first data block, that the first data block is the final data block of the target stripe, wherein the location identifier indicates a storage location of the first data block in the target stripe.

13. The apparatus according to any one of claims 8 to 11, wherein the transceiver unit is specifically configured to:
send combination indication information to the server; and
receive the combination indication information, and determine that the first data block is the final data block of the target stripe.

14. A compute device, comprising a processor, wherein the processor is coupled to a memory, the processor is configured to store instructions, and when the instructions are executed by the processor, the compute device is caused to perform the method according to any one of claims 1 to 6.

15. A compute device cluster, comprising at least one compute device, wherein the compute device comprises a processor, the processor is coupled to a memory, the processor is configured to store instructions, and when the instructions are executed by the processor, the compute device cluster is caused to perform the method according to any one of claims 1 to 6.

16. A computer-readable storage medium, storing instructions, wherein when the instructions are executed, a computer is caused to perform the method according to any one of claims 1 to 6.

17. A computer program product, wherein the computer program product comprises instructions, and when the instructions are executed, a computer is caused to implement the method according to any one of claims 1 to 6.
